# EUROPÄISCHE PATENTSCHRIFT

(11) **EP 2 678 265 B1**
(45) Veröffentlichungstag und Bekanntmachung des Hinweises auf die Patenterteilung: **01.08.2018**
(21) Anmeldenummer: 12710454.5
(22) Anmeldetag: 24.02.2012
(51) Int. Cl.: B81B 3/00

(54) **ABLÖSBARE MIKRO- UND NANOBAUTEILE FÜR PLATZSPARENDEN EINSATZ**
DETACHABLE MICRO- AND NANO-COMPONENTS FOR A SPACE-SAVING USE
COMPOSANTS MICROMÉTRIQUES ET NANOMÉTRIQUES AMOVIBLES POUR UTILISATION NÉCESSITANT PEU D'ESPACE

(30) Priorität: 25.02.2011 DE 102011004782
(43) Veröffentlichungstag der Anmeldung: 01.01.2014
(73) Patentinhaber: HARTING AG & Co. KG, 32339 Espelkamp (DE)
(72) Erfinder: GATZEN, Hans-Heinrich, 30916 Isernhagen (DE); GRIESBACH, Tim, 75417 Mühlacker (DE)
(74) Vertreter: Eisenführ Speiser
(86) Internationale Anmeldenummer: PCT/EP2012/053147
(87) Internationale Veröffentlichungsnummer: WO 2012/113902

(56) Entgegenhaltungen:
- WO-A2-2007/081688
- US-A1- 2002 181 110
- LIANG WANG ET AL: "A novel approach to embed off-chip RF passives in PCB based on thin film technology", ELECTRONIC SYSTEM-INTEGRATION TECHNOLOGY CONFERENCE (ESTC), 2010 3RD, IEEE, PISCATAWAY, NJ, USA, 13. September 2010 (2010-09-13), Seiten 1-4, XP031806702, ISBN: 978-1-4244-8553-6
- TAGUCHI M ET AL: "DEFORMATION CONTROL OF METAL/NITRIDE MICROBRIDGES", IEICE TRANSACTIONS ON ELECTRONICS, INSTITUTE OF ELECTRONICS, TOKYO, JP, Bd. E80-C, Nr. 2, 1. Februar 1997 (1997-02-01), Seiten 221-225, XP000773351, ISSN: 0916-8524
- LANG W ET AL: "STRESS COMPENSATION TECHNIQUES IN THIN LAYERS APPLIED TO SILICON MICROMACHINING", MATERIALS RESEARCH SOCIETY SYMPOSIUM PROCEEDINGS; [MATERIALS RESEARCH SOCIETY SYMPOSIUM PROCEEDINGS], MATERIALS RESEARCH SOCIETY, PITTSBURG, PA; US, Bd. 284, 1. Januar 1993 (1993-01-01), Seiten 119-125, XP000614092, ISBN: 978-1-55899-828-5
- GLORIA Y YANG ET AL: "Parylene-Based Strain Sensors for Bone", IEEE SENSORS JOURNAL, IEEE SERVICE CENTER, NEW YORK, NY, US, vol. 7, no. 12, 1 December 2007 (2007-12-01), pages 1693-1697, XP011196181, ISSN: 1530-437X, DOI: 10.1109/JSEN.2007.909923

## Beschreibung

Die vorliegende Erfindung bezieht sich auf Herstellung von ablösbaren Bauteilen für platzsparenden Einsatz in der Mikro- und Nanosystemtechnik sowie -elektronik (Detachable Components for Space-limited Applications through Micro and Nano Technology - DECAL-MNT).

Die Mikro- und Nanosystemtechnik umfasst den Entwurf, die Fertigung und die Anwendung von miniaturisierten technischen Systemen, deren Elemente und Komponenten Strukturgrößen im Mikrometer- und Nanometerbereich besitzen. Mikrosysteme setzen sich aus mehreren Komponenten zusammen, diese wiederum umfassen Funktions- und Strukturelemente. Hierbei kann sich ein Funktionselement eines Bauteils aus mehreren Schichten zusammen setzen, die nachfolgend auch als Schichtstruktur eines Bauteils bezeichnet wird. Ein Mikrosystem kann z.B. ein Airbag-Auslösesystem, Antennensystem, intelligentes Sensorsystem, Mikromotor, Mikroanalysesystem oder Lichtmodulator darstellen. Die Komponenten können z.B. mikromechanisch, mikroelektronisch, mikrofluidisch oder mikrooptisch basiert sein um z.B. sensorische, aktorische, Übertragungs-, Speicher- oder Signalverarbeitungsfunktionen zu übernehmen. Die Funktions- und Formelemente können z.B. Biegebalken, Membran, Anschlag, Lager, Kanal, Metallisierung, Passivierung, Piezowiderstand, Heizwiderstand und Leiterzug sein. Die Verwendung des Begriffs "Bauteil" umfasst alle Mikro- und Nanosysteme, die sowohl nichtelektrische als auch elektrische, insbesondere mikroelektronische Komponenten aufweisen, hierunter sind auch Konstruktionselemente zu verstehen, bei denen es sich um Vorstadien der letztendlich zu erzeugenden Bauteile handelt, wobei sich die Mindestabmessung nicht auf den Mikrometerbereich beschränkt, sondern auch im Nanometerbereich liegt.

Die Fertigung von Mikrostrukturen erfolgt durch Aufbringung mehrerer unterschiedlicher Materialschichten mittels mehrerer unterschiedlicher Verfahrensschritte. Der Begriff "Materialschicht" umfasst alle Schichten, die während der Herstellung eines Bauteils temporär - wie z.B. eine Opferschicht - oder zum dauerhaften Verbleib zum Einsatz kommen. Die Materialschichten besitzen unterschiedliche physikalische Charakteristiken, insbesondere zeichnen sie sich durch verschiedene thermische Ausdehnungskoeffizienten aus. Die Fertigung eines Bauteils durch Aufbringung mehrerer Materialschichten erfolgt meist bei einer Temperatur oberhalb der Raumtemperatur, sodass eine nachträgliche Temperaturänderung zur unerwünschten mechanischen Spannungen, insbesondere Zug- und/oder Druckspannungen führt. Diese haben dann eine Verformung und/oder Verwölbung der einzelnen Materialschichten des Bauteils zur Folge. Desweiteren können die mechanischen Spannungen die Haftung zwischen den einzelnen Materialschichten negativ beeinflussen und zur Ablösung, Verschiebung oder Zerstörung des Bauteils führen. Die vorgenannten Effekte beeinträchtigen die Funktionsfähigkeit der Mikrostruktur und können diese teilweise oder gänzlich außer Betrieb setzen.

Im heutigen Stand der Technik wird in erster Linie dafür gesorgt, dass die einzelnen Materialschichten eines Bauteils sehr stark aneinander haften, sodass die entstehenden mechanischen Spannungen von einem starren Substrat, welches als Strukturelement dient und meist der Wafer ist, aufgenommen werden. Der Begriff "Substrat" umfasst alle zusätzlichen Elemente zur Einhaltung einer vorbestimmten Form und/oder zur Aufnahme mechanischer Spannungen. Ein Substrat bzw. ein Wafer weist allerdings eine beträchtliche Materialstärke bzw. Materialdicke (z.B. 4-Zoll-Wafer: 525 µm) auf, die eine nachträgliche Materialabtragung mittels Schleifprozess, Ätzen oder einer Kombination der beiden bedarf, um so einen gedünnten Wafer (z.B. gedünnter 4-Zoll-Wafer: 50 µm) zu erhalten. Die nachträgliche Materialabtragung zur Erhöhung des Miniaturisierungsgrads ist mit erhöhtem Arbeits- und Kostenaufwand verbunden, die sich negativ auf die Wirtschaftlichkeit niederschlagen. Desweiteren kann meist keine vollständige Waferabtragung durchgeführt werden, sodass der Miniaturisierungsgrad verringert wird. Desweiteren werden Mikrobauteile oder Nanobauteile nach der Fertigung auf Waferniveau vereinzelt. Dies erfolgt am häufigsten durch Trennschleifen. Die so vereinzelten Bauteile werden auch als Chips bezeichnet. Um Mikrobauteile oder Nanobauteile in ein System zu integrieren ist eine aufwendige Aufbau und Verbindungstechnik notwendig. Die Aufbautechnik dient dabei hauptsächlich der mechanischen Verbindung des vereinzelten Bauteils mit einem Träger. Dieser Träger kann ein Bauteilgehäuse sein, mit dem das Bauteil durch Bonden verbunden wird, aber auch direkt eine Leiterplatte, auf welcher das Bauteil gehäuselos montiert wird. Die Verbindungstechnik dient dazu, die für die elektrische oder elektronische Systemintegration des Bauteils notwendigen elektrischen Verbindungen herzustellen. Dazu weist das Bauteil an seiner Peripherie Kontaktflecken bzw. Kontaktbereiche auf. So wird beispielsweise durch Anschweißen von Mikrodrähten eine Verbindung zwischen Kontaktflecken des Bauteils und den Kontaktstiften des Gehäuses hergestellt. Diese werden dann beispielsweise in einer Leiterplatte, der nächst höheren Komponente in der Systemintegration, eingelötet. Ein anderes Verfahren ist, die vereinzelten Bauteile an den Kontaktflecken mit kleinen Lötkugeln zu versehen und mit der Bauteileseite und damit auch den Kontaktflecken nach unten direkt auf den Kontakten eines Trägers festzulöten. Wegen des hierbei erfolgten Umdrehens des Bauteils wird dieser Ansatz als Flip-Chip-Technik bezeichnet. Bei ihr entsteht durch die Lötverbindung zwischen den Kontakten nicht nur eine elektrische, sondern auch eine mechanische Verbindung.

Ferner wird als weiterer Stand der Technik auf US 2002/0181110 A1 (Device having a barrier layer located therein and a method of manufacture therefor) sowie Liang Wang et. al "A novel approach to embed off-chip RF passives in PCB based on thin film technology", Electronic System-Integration Technology Conference (ESTC), 2010 3RD, IEEE, Piscataway, NJ, USA, 13. September 2010, Seiten 1 bis 4 sowie Taguchi M. et al "Deformation control of metal/nitride microbridges", IEICE Transactions on Electronics, Institute of Electronics, Tokyo, JP, Bd. E80-C, Nr. 2, 1 Februar 1997, Seiten 221 bis 225 sowie Lang W. et al "Stress compensation techniques in thin layers applied to silicon micromachining", Materials Research Society Symposium Proceedings; Materials Research Society, Pittsburg, PA; US, Bd. 284, 1. Januar 1993, Seiten 119 bis 125, verwiesen. Aus GLORIA Y YANG ET AL: "Parylene-Based Strain Sensors for Bone",IEEE SENSORS JOURNAL, IEEE SERVICE CENTER, NEW YORK, NY, US, Bd. 7, Nr. 12, 1. Dezember 2007 (2007-12-01), Seiten 1693-1697, ist zudem ein Sensor bekannt, der aus einer Metallschicht, die in zwei spannungsfreie Parylene-C-Schichten eingebettet ist, besteht. Dieser Sensor ist ca. 12 µm dick und wird auf einem Wafer hergestellt, von dem er am Ende des Verfahrens abgelöst wird. Aus DE 19851967A1 ist ein Mikrospiegel mit einer permanent induzierten mechanischen Spannung verwölbten Membran bekannt. Die Verwölbung der Membran wird über ein Aufbringen einer tensil verspannten Schicht auf einen monolithischen Membrangrundkörper oder eine Dotierung mit Fremdatomen mit unterschiedlichen Atomradien erreicht.

Aus "IEEE Journal of Microelectromechanical Systems, Vol. 9, No. 4, December 2000" ist die Publikation "A New Technique for Producing Large-Area As-Deposited Zero-Stress LPVCD Polysilicon Films: The MultiPoly Process" bekannt, die sich mit der Regulierung und Eliminierung von verbleibenden Spannungen und Spannungsgradienten zur Verbesserung von Bauelementen beschäftigt. Hierbei werden Schichten mit einer Dehnspannung und einer Druckspannung alternierend aufeinander angebracht.

Aus DE 101 62 983 A1 ist eine Kontaktfederanordnung bekannt, bei der auf einem Substrat eine einseitig fixierte Kontaktfeder angeordnet ist, die aus einem einen Stressgradienten aufweisenden Halbleitermaterial besteht, der eine dauerhafte Verbiegung der Kontaktfeder verursacht. Der Stressgradient im Halbleitermaterial wird durch zwei miteinander verbundene und unterschiedlich mechanisch verspannte Halbleiterschichten hervorgerufen.

Aus DE 60 2004 010 729 T2 ist die Kombination von physikalischem Gasphasenabscheiden (PVD) und chemischem Gasphasenabscheiden (CVD) bekannt.

Aus US 2002/0014673 A1 sind Verfahren zur Herstellung von integrierten Schaltungen auf flexiblen Membranen bekannt, wobei die Verfahren nicht auf ein Halbleitersubstrat als erste Schicht zurückgreifen.

Aus DE 10 2006 057 568 A1 sind mikrooptische Elemente mit einem Substrat und Verfahren zur Herstellung der vorgenannten Elemente unter Verwendung von Opferschichten, bekannt.

Aus US 6,098,568 ist die Verwendung von niedrigen Strahlungsfrequenzen zur Steuerung der lonenenergie beim Bombardieren von Substraten zur besseren Kontrolle von mechanischen Spannungen bekannt.

Keine der vorgenannten Referenzen des Standes der Technik beschrieb ein Verfahren zur Herstellung von mechanisch spannungskompensierten Bauteilen. Desweiteren beschrieb keine der vorgenannten Referenzen ein effektiv mechanisch spannungskompensiertes Bauteil.

Aufgabe der Erfindung ist es, eine Lösung zu finden, um wenigstens einen der genannten Nachteile zumindest zu verringern. Insbesondere soll eine Lösung zur Herstellung von ablösbaren und platzsparenden Mikro- und Nanobauteilen vorgeschlagen werden.

Zur Lösung dieser Aufgabe wird erfindungsgemäß ein Bauteil gemäß Anspruch 1 vorgeschlagen. Das erfindungsgemäße Bauteil, welches ein Sensor ist, weist eine Dicke von etwa 1 bis 50 µm auf und ist mechanisch spannungskompensiert, sodass ein Wölben oder Faltenwerfen verhindert wird. Aufgrund der mechanischen Spannungskompensation des Bauteils, kommt kein starres Element wie zum Beispiel ein Substrat (ein Wafer, ein Strukturelement oder ein gedünntes Substrat) zur Verhinderung von Wölbungen oder Falten zum Einsatz. Der Verzicht auf ein starres Substrat, welches eine erhebliche Dicke aufweist führt zur Realisierung eines Bauteils mit einer geringen Bauhöhe bzw. Dicke.

Gemäß der vorliegenden Erfindung weist das Bauteil zumindest eine Spannungskompensationsschicht mit einer vorbestimmten mechanischen Spannung auf, sodass die Spannungskompensationsschicht zumindest eine mechanische Spannung des Bauteils zumindest teilweise kompensiert. Hierbei wird beim Vorliegen von mechanischen Spannungen des Bauteils mit Hilfe von mechanischen Spannungskompensationsschichten eine Kompensation der herrschenden Zug- und/oder Druckspannungen durchgeführt, sodass ein Wölben oder Faltenwerfen verhindert wird. Dünne Bauteile, welche auf einen Wafer als starres Substrat verzichten, sind trotz ihrer wesentlich kleineren Abmessung im Vergleich zu einem gesamten Wafer besonders anfällig gegenüber einer Verwölbung. Wünschenswert dagegen ist, dass die vom Wafer abgelösten Bauteile flach und unverwölbt sind. Hierbei kann das Bauteil auch über mehrere Spannungskompensationsschichten verfügen. In diesem Fall werden mehrere Spannungskompensationsschichten während der Herstellung des Bauteils abgeschieden, sodass das Bauteil eine kontinuierliche mechanische Spannungskompensation erfährt. Dabei kann auch eine in geeigneter Weise abgeschiedene Schicht der für die Bauteilfunktion notwendigen Schichtstrukturen des Bauteils als Spannungskompensationsschicht dienen. Somit können sich die Spannungskompensationsschichten zwischen den Schichtstrukturen des Bauteils zum Einsatz kommen. Das Abscheiden einer Spannungskompensationsschicht mit einer vorbestimmten mechanischen Spannung erfolgt mittels verschiedener Abscheidungsprozesse, insbesondere durch chemische Gasphasenabscheidung (CVD) und physikalische Gasphasenabscheidung (PVD). Die CVD-Verfahren können bei atmosphärischem Druck (APCVD), reduziertem Druck (RPCVD) und plasmagestützt (PECVD) erfolgen. Die PVD-Verfahren können mittels thermischer Prozesse oder Sputtern, insbesondere durch lonenstrahlzerstäubung oder Plasmazerstäubung erfolgen.

Bei einer weiteren bevorzugten Ausführungsform des erfindungsgemäßen Bauteils weist das Bauteil zumindest eine erste Einbettungsschicht auf. Hierbei werden die Schichtstrukturen des Bauteils eingebettet und somit innerhalb der ersten Einbettungsschicht integriert.

Gemäß einer Option der vorliegenden Erfindung weist das Bauteil zumindest eine zweite Einbettungsschicht auf. Die zweite Einbettungsschicht dient der Einbettung von Durchführungen und des Kontaktierungsbereiches, sodass diese in der zweiten Einbettungsschicht integriert sind.

Bei einer weiteren bevorzugten Ausführungsform des erfindungsgemäßen Bauteils weist das Bauteil zumindest einen Kontaktierungsbereich auf. Diese ermöglicht die Kontaktherstellung mit weiteren Bauteilen und Komponenten des Systems, dem das Bauteil angehört und die Übertragung und/oder den Empfang von Signalen. Zur Systemintegration wird die Seite des Bauteils, welches die Kontaktierungsbereiche aufweist, auf einem Träger aufgebracht. Auch dieser Träger weist Kontaktierungsbereiche auf, diese sind spiegelbildlich zu den Kontaktierungsbereichen des Bauteils. Die Montage erfolgt so, dass die Kontaktierungsbereiche von Bauteil und Träger in Kontakt sind. Die Verbindung des Bauteils mit seinem Träger erfolgt bevorzugt durch Kleben, wobei der Kleber im Bereich der Kontaktierungsbereiche elektrisch leitend sein muss. Als Träger dienen bevorzugt starre Leiterplatten, flexible Flachkabel oder Molded Interconnect Devices (MID), dreidimensionale, mit Leitern versehene Trägerstrukturen, wie sie beispielsweise bei Mobiltelefonen zum Einsatz kommen.

Gemäß einer Option der vorliegenden Erfindung weist das Bauteil zumindest eine Durchkontaktierung auf. Hierbei dient die Durchkontaktierung der Herstellung einer Verbindung zwischen dem signalerzeugenden und/oder signalempfangenden Teil des Bauteils und dem Kontaktierungsbereich, insbesondere kommt die Durchkontaktierung zur Verbindungsherstellung zwischen dem Bauteilbereich, welcher elektrische Signale erzeugt und dem Kontaktierungsbereich zur Kommunikation mit weiteren Komponenten oder Systemen zum Einsatz.

Gemäß einem weiteren Aspekt der vorliegenden Erfindung ist das Bauteil zur Ausführung von sensorischen und/oder aktorischen Aufgaben eingerichtet. Die Bauteile können zur Ausführung verschiedener Aufgaben entworfen und hergestellt werden, sodass diese vielfältige Aufgaben durchführen können. Diese Bauteile sind ultradünn und besitzen kein Substrat, sodass deren geringe Dicke die Integration in technische Systeme erleichtert. Zum Beispiel können auf einem flexiblen Flachkabel eine Vielzahl von Temperatursensoren gemäß der vorliegenden Erfindung aufgebracht werden und so an vielen unterschiedlichen Stellen Temperaturmessungen vorgenommen werden. Es können ferner Dehnungsmesssensoren an verschiedensten Stellen direkt an den zu messenden Strukturen angebracht werden und durch ein über den Bauteilen verlaufendes flexibles Flachkabel untereinander oder mit einem Auswertesystem verbunden werden. Im Falle von lokalen Datennetzwerken können Antennen gemäß dieser Erfindung direkt auf dem Gehäuse aufgebracht werden.

Gemäß einem weiteren Aspekt der vorliegenden Erfindung ist das Bauteil zur Signalübertragung und/oder zum Signalempfang eingerichtet. Auch diese Bauteile sind ultradünn, besitzen kein Substrat und können in technische Systeme integriert werden.

Gemäß einer bevorzugten Ausführungsform der vorliegenden Erfindung wird ein Bauteilsystem bestehend aus zumindest zwei Bauteilen nach den oben genannten Ausführungsformen vorgeschlagen. Das Bauteilsystem setzt sich aus identischen oder unterschiedlichen Bauteilen zusammen, die zur Ausführung von sensorischen und aktorischen Aufgaben vorgesehen sind. Hierdurch können unterschiedliche Bauteilsysteme entstehen die eine bestimmte Kombination von Aufgaben durchführen können. Die platzsparende Eigenschaft der Bauteile und die Herstellungsverfahren in der Mikro- und Nanosystemtechnik können vorteilhaft zur Herstellung von diesen Bauteilsystemen eingesetzt werden, sodass in einem Herstellungsprozess mehrere verschiedene Bauteile zur Übernahme verschiedener Aufgaben gleichzeitig hergestellt werden und somit ein Bauteilsystem entsteht, in welchem die einzelnen Bauteile teilweise miteinander in Verbindung stehen und kommunizieren können.

Gemäß einer weiteren Option der vorliegenden Erfindung wird ein Bauteilsystem bestehend aus zumindest zwei Bauteilen nach den oben genannten Ausführungsformen zur Signalübertragung und/oder zum Signalempfang vorgeschlagen. Das Bauteilsystem setzt sich aus identischen oder unterschiedlichen Bauteilen zusammen, die zum Signalempfang und/oder zur Signalübertragung vorgesehen sind. Hierbei können auch verschiedene Bauteilsysteme miteinander verbunden werden, sodass komplexe Aufgaben durch die Kombinationsmöglichkeiten der einzelnen Bauteilsysteme durchgeführt werden.

Gemäß der vorliegenden Erfindung wird ein Verfahren zur Herstellung eines substratlosen Bauteils, welches ein Sensor ist, mit einer Dicke von etwa 1 bis 50 µm auf einer Opferschicht vorgeschlagen. Das Verfahren umfasst mehrere Schritte. Der erste Schritt ist der schichtweise Aufbau des Bauteils mittels verschiedener physikalischer und/oder chemischer Prozesse. Der Aufbau der einzelnen Schichten erfolgt derart, dass jede einzelne Schicht des Bauteils eine vorbestimmte mechanische Spannung aufweist, wobei die mechanischen Spannungen der einzelnen Schichten des Bauteils sich im Wesentlichen kompensieren, um ein Wölben oder Faltenwerfen zu verhindern. Hierbei wird das Bauteil auf einer Opferschicht aufgebaut. Nach der Herstellung des Bauteils wird mittels physikalischer und/oder chemischer Verfahren die Opferschicht entfernt. Hierbei wird auf chemische und physikalische Prozesse zur Entfernung von Materialschichten wie z.B. Trockenätzverfahren und nasschemische Ätzverfahren zurück gegriffen. Nach der Entfernung der Opferschicht kann das Bauteil entnommen und anschließend an einer gewünschten Position platziert werden. Gemäß diesem Verfahren können trägerschichtlose Sensoren hergestellt werden.

Gemäß einer Weiterbildung der vorliegenden Erfindung wird ein Verfahren zur Herstellung eines substratlosen Sensors mit einer Dicke von etwa 1 bis 50 µm auf einer Opferschicht vorgeschlagen. Das Verfahren umfasst mehrere Schritte und zeichnet sich dadurch aus, dass der erste Schritt des vorgenannten Verfahren durch eine Kombination aus schichtweisem Aufbau des Bauteils oder des Bauteilsystems mittels verschiedener physikalischer und/oder chemischer Prozesse und dem Abscheiden einer Spannungskompensationsschicht mittels CVD und/oder PVD an dem Bauteil oder innerhalb der Schichtstruktur des Bauteils zur zumindest teilweisen Kompensation von mechanischen Spannungen des Bauteils, um ein Wölben oder Faltenwerfen zu verhindern, realisiert wird. Hierbei wird durch die Abscheidung von zumindest einer Spannungskompensationsschicht an dem Bauteil oder innerhalb der Schichtstruktur des Bauteils, die mechanische Spannung infolge einer Temperaturänderung kompensiert. Die Parameter zur Abscheidung einer Spannungskompensationsschicht mit einer vorbestimmten mechanischen Spannung können mittels Berechnungen, Simulationen oder experimenteller Ausführungen ermittelt werden. Anschließend erfolgt wiederum das Entfernen der Opferschicht mittels eines physikalischen und/oder chemischen Verfahrens, sodass das Bauteil abschließend entnommen wird. Gemäß diesem Verfahren können trägerschichtlose Bauteile hergestellt werden, die durch die abgeschiedenen Spannungskompensationsschichten mechanisch spannungskompensiert sind.

Gemäß einer weiteren Weiterbildung der vorliegenden Erfindung wird ein Verfahren zur Herstellung eines substratlosen Sensors mit einer Dicke von etwa 1 bis 50 µm auf einer Opferschicht vorgeschlagen. Das Verfahren umfasst mehrere Schritte und zeichnet sich dadurch aus, dass nach dem schichtweisen Aufbau des Bauteils mittels verschiedener physikalischer und/oder chemischer Prozesse oder nach einer Kombination mit dem vorgenannten Schritt zum Abscheiden einer Spannungskompensationsschicht mittels CVD und/oder PVD an dem Bauteil oder innerhalb der Schichtstruktur des Bauteils zumindest eine Hilfsschicht an dem Bauteil angebracht wird. Unter einer Hilfsschicht werden zum Beispiel, Handhabungsschichten, Klebeschichten oder Schutzschichten verstanden, die auch in verschiedenen Kombinationen zusammengesetzt sein können und an dem Bauteil angebracht werden. Die Handhabungsschicht haftet temporär oder dauerhaft an dem Bauteil und dient der Entnahme des Bauteils, sodass das Bauteil an einer anderen Position platziert werden kann. Desweiteren kann mittels einer Hilfsschicht bzw. einer Handhabungsschicht mehrere Bauteile nebeneinander angehaftet werden, sodass eine flexible Folie bestehend aus mehreren Bauteilen oder Bauteilsystemen zur Verfügung steht. Die Handhabungsschicht könne verschiedene Ausführungsformen und Materialien aufweisen und variabel kombiniert werden.

Bei einem weiteren bevorzugten Verfahren gemäß der vorliegenden Erfindung erfolgt nach dem Umpositionieren des Bauteils das Entfernen von zumindest einer Hilfsschicht. Desweiteren ist es möglich unter Verwendung einer mehrschichtigen Handhabungsschicht eine Schicht der Handhabungsschicht zumindest bereichsweise zu entfernen, wobei die darunterliegende Schicht zum Beispiel eine Klebeeigenschaft aufweisen kann, um das Bauteil an einer vorgesehenen Position aufzukleben. Hierbei kann durch geeignete Auswahl und Kombination von Hilfsschichten, die aus unterschiedlichen Materialien hergestellt sein können, eine Anbringung des Bauteils nach der Art eines Abziehbildes realisieren.

Bei einem weiteren bevorzugten Verfahren gemäß der vorliegenden Erfindung erfolgt das Abscheiden der Spannungskompensationsschicht mittels plasmaunterstützter chemischer Abscheidung aus der Dampfphase bei zumindest einer Abscheidungsfrequenz, insbesondere zwei Abscheidungsfrequenzen, sodass die mechanische Spannung der Spannungskompensationsschicht mittels der Abscheidungsfrequenz eingestellt werden kann. Hierbei kommen vorzugsweise anorganische Isolierschichten wie z.B. Si3N4 zum Einsatz. Bei Wahl der höheren Frequenz weist die abgeschiedene Schicht Zugspannungen auf und bei Wahl der niedrigen Frequenz vergrößert sich die mittlere freie Weglänge der Ionen des Plasmagases dergestalt, dass sie die im Aufbau befindliche Materialschicht bombardieren und damit Druckspannung erzeugen. Durch die Kombination von zwei Teilschichten, bei der die eine Zugspannungen aufweist und die andere Druckspannungen, lässt sich in der Gesamtschicht eine Zugspannung oder eine Druckspannung weitgehend beliebiger Größe einstellen.

Im Folgenden werden einige Ausführungsbeispiele und prinzipielle Herstellungsschritte von erfindungsgemäßen Bauteilen beispielhaft anhand der Figuren 1 bis 12 mit den wesentlichen Verfahrensschritten beschrieben.
Figur 1 zeigt schematisch die Wölbung eines Bauteils (2) aufgrund der herrschenden Druck- und Zugspannungen (D, Z).
Figur 2 zeigt schematisch ein Bauteil (2) und seine Schichtstrukturen (2a) auf einem nicht-gedünnten Substrat (1a).
Figur 3 zeigt schematisch ein Bauteil (2) und seine Schichtstrukturen (2a) mit einem gedünnten Substrat (1b) gemäß dem Stand der Technik.
Figur 4 zeigt schematisch ein Bauteil (2), welches eine abgeschiedene Spannungskompensationsschicht (5) mit der Kompensationsspannung (K) zur Kompensation der herrschenden Druck- und Zugspannungen (D, Z) des Bauteils (2) aufweist.
Figur 5 zeigt schematisch ein ablösbares Bauteil (2), welches eine Spannungskompensationsschicht (5) aufweist.
Figur 6 zeigt schematisch das ablösbare Bauteil von Figur 5 nach der Ablösung.
Figur 7 zeigt schematisch gemäß der Erfindung, ein spannungskompensiertes abgelöstes Bauteil (2) mit einer ersten Einbettungsschicht (7) und einer zweiten Einbettungsschicht (7a).
Figur 8 zeigt schematisch ein spannungskompensiertes Bauteil (2) mit einer ersten Einbettungsschicht (7).
Figur 9 zeigt schematisch ein erfindungsgemäßes ablösbares Bauteil (2), welches mehrere Hilfsschichten (6) aufweist.
Figur 10 zeigt das erfindungsgemäße Bauteil (2) von Figur 9 nach der Ablösung vom Wafer bzw. Substrat (1a).
Figur 11 zeigt das erfindungsgemäße Bauteil (2) von Figur 10 nach dem Entfernen der obersten Hilfsschicht (6).
Figur 12 zeigt das erfindungsgemäße Bauteil (2) von Figur 11 nach dem Entfernen der obersten Hilfsschicht (6).

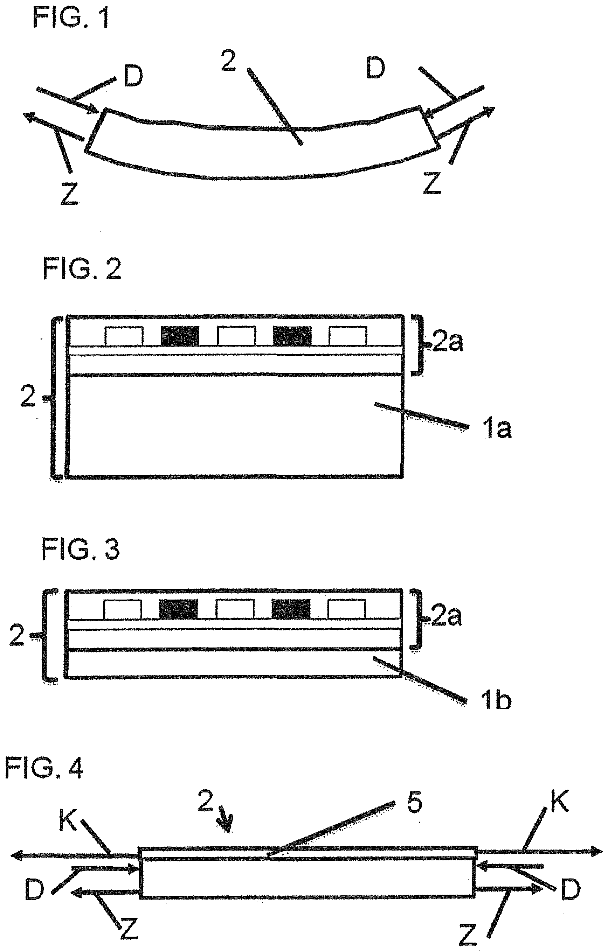

Figur 1 zeigt exemplarisch ein loses Bauteil (2), welches aufgrund einer Druckspannung (D) und einer Zugspannung (Z) gekrümmt ist und in gewölbter Form vorliegt. Die Figur 2 zeigt, wie die vorgenannte Krümmung gemäß dem Stand der Technik durch die Herstellung des Bauteils (2) auf einem starren und dicken Wafer bzw. Substrat (1a) verhindert wird. Unter der Voraussetzung eines ausreichenden Aneinanderhaftens der einzelnen Schichten des Bauteilschichtsystems bzw. der Bauteilschichtstruktur (2a) werden die herrschenden Druck- und Zugspannungen (D, Z) von dem starren Wafer bzw. Substrat (1a) aufgenommen, sodass das Bauteil (2) keine Wölbung aufweist. Gemäß dem Stand der Technik, wird wie in Figur 3 dargestellt, zur Verkleinerung der Dicke des Bauteils (2), das Substrat bzw. der Wafer (1a) anschließend mittels Schleifens und/oder Ätzens gedünnt, sodass ein gedünntes Substrat (1b) vorliegt, welches die Dicke des gesamten Bauteils (2) reduziert.

Figur 4 stellt schematisch den Einsatz einer erfindungsgemäßen Spannungskompensationsschicht (5) zur Kompensation der mechanischen Spannungen des Bauteils (2) dar. Hierbei werden die herrschenden Druck- und Zugspannungen (D, Z) des Bauteils (2) durch die abgeschiedene Spannungskompensationsschicht (5) mit einer mechanischen Kompensationsspannung (K) im Wesentlichen kompensiert.

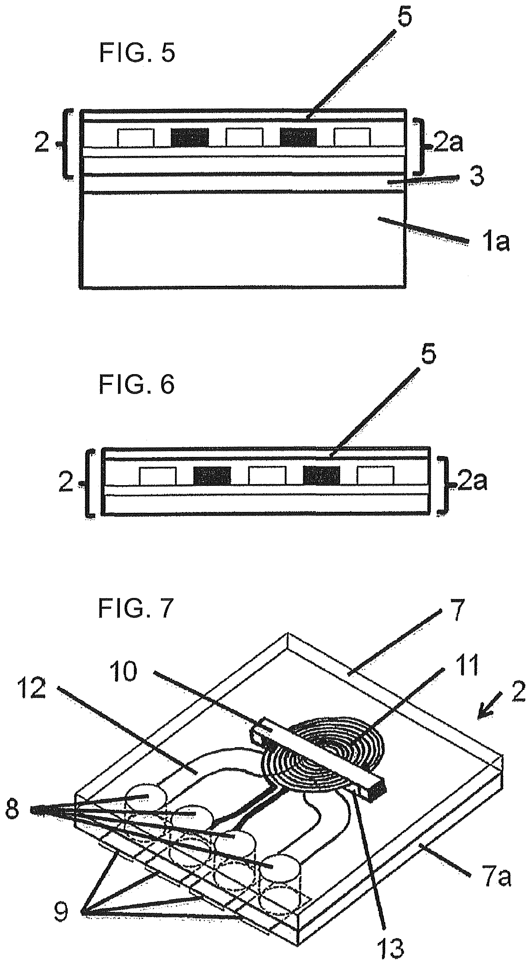

Figur 5 zeigt ein erfindungsgemäßes Bauteil (2), welches direkt auf einer Opferschicht (3) hergestellt ist und eine Spannungskompensationsschicht (5) aufweist. Die abgeschiedene Spannungskompensationsschicht (5) kompensiert die mechanischen Spannungen des Bauteils (2) bzw. der Strukturschicht des Bauteils (2a) im Wesentlichen, sodass nach dem anschließenden Entfernen der Opferschicht (3), wie in Figur 6 dargestellt, ein sehr dünnes Bauteil (2) mit einer Gesamtdicke von ca. 1 bis 50 µm zur Verfügung steht. Diese Ausführungsform ermöglicht das Anbringen des Bauteils (2) auf jede beliebige Unterlage.

Figur 7 stellt eine modular und spannungskompensiert aufgebautes Bauteil (2) gemäß einem Aspekt der vorliegenden Erfindung dar. Das in Figur 7 dargestellte Bauteil (2) ist ein Sensor, welcher sich aus verschiedenen modularen in einer ersten Einbettungsschicht (7) integrierten Komponenten: Durchkontaktierung (8), Flussführung (10), Sensorspule (11), Erregerspule (12) und magnetoelastische Flussführung (13) zusammensetzt. Eine zweite Einbettungsschicht (7a) dient der Integration der Durchkontaktierungen (8) und der Kontaktierungsbereiche (9). Die Gesamtdicke des Sensors ist durch den spannungskompensierten Aufbau erheblich reduziert.

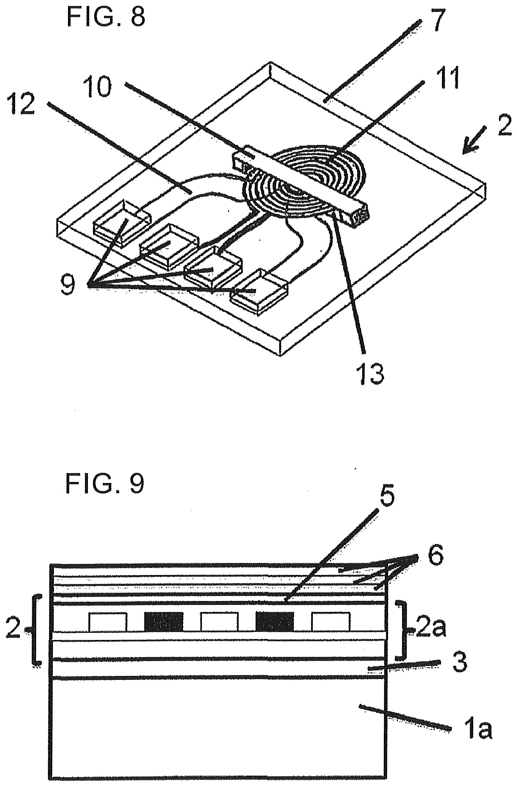

Figur 8 stellt ein modular und spannungskompensiert aufgebautes Bauteil (2) gemäß einem weiteren Aspekt der vorliegenden Erfindung dar. Das dargestellte Bauteil (2) in Figur 8 ist ein Sensor, welcher sich aus verschiedenen modularen in einer ersten Einbettungsschicht (7) integrierten Komponenten: Kontaktierungsbereich (9), Flussführung (10), Sensorspule (11), Erregerspule (12) und magnetoelastische Flussführung (13) zusammensetzt. Hierbei weist das Bauteil (2) keine zweite Einbettungsschicht (7a) auf. Der Sensor kann auf einer beliebige Unterlage angebracht und positioniert werden.

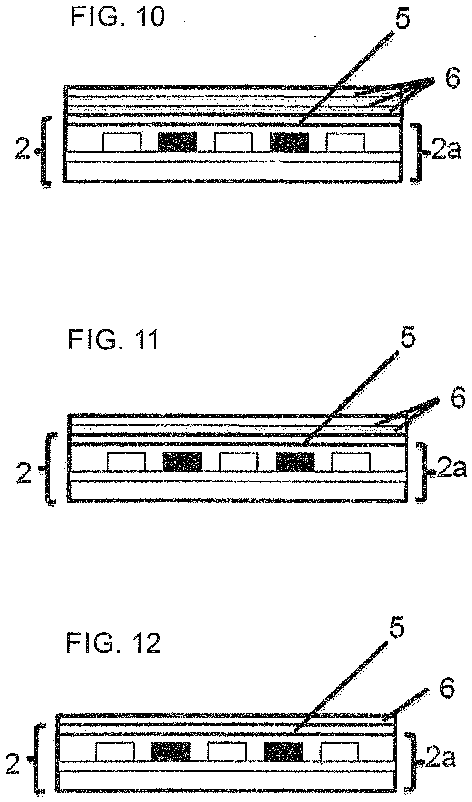

Figur 9 zeigt eine Bauteilschichtstruktur (2a), welche auf einer Opferschicht (3) hergestellt ist und eine Spannungskompensationsschicht (5) aufweist. Zusätzlich weist das Bauteil mehrere Hilfsschichten (6) auf, die dem Handhaben, Kleben und Schützen des Bauteils dienen und kommen, wie bereits oben beschrieben für verschiedene Aufgaben zum Einsatz. Desweiteren kann bei der in Figur 10 vorliegenden Ausführungsform eine im Vergleich zu einem Fall, bei dem eine Trägerschicht zum Einsatz kommt, kleinere Gesamtdicke des Bauteils (2) erreicht werden, sodass ein Bauteil (2) nach der Art eines Abziehbildes zur Verfügung steht. Desweiteren ist vorgesehen, dass zumindest eine Schicht der Handhabungsfolie zumindest bereichsweise entfernt werden kann. Hierbei wird zumindest eine Schicht der Handhabungsschicht nach der Entnahme und Positionierung des Bauteils entfernt, sodass die Oberfläche des Bauteils freigelegt wird. Zusätzlich kann bei einer entsprechenden mehrschichtigen Handhabungsschicht die oberste Schicht, die eine Schutzfunktion erfüllt, entfernt werden.

Figur 11 zeigt die erfindungsgemäße Bauteilschichtstruktur (2a) aus Figur 10 nach dem die oberste Hilfsschicht (6) entfernt worden ist. Zusätzlich zeigt Figur 12 Bauteilschichtstruktur (2a) aus Figur 11 nach dem Entfernen einer weitere Hilfsschicht (6).

## Patentansprüche

1. Sensor (2) mit einer Dicke von 1 bis 50 µm,
wobei der Sensor (2) substratlos ist und zumindest eine Spannungskompensationsschicht (5) mit einer vorbestimmten mechanischen Spannung zur Kompensation der herrschenden Zug- oder Druckspannungen aufweist, um ein Wölben oder Faltenwerfen zu verhindern.

2. Sensor (2) nach einem der vorgenannten Ansprüche,
wobei der Sensor (2) zumindest eine erste Einbettungsschicht (7) aufweist.

3. Sensor (2) nach einem der vorgenannten Ansprüche,
wobei der Sensor (2) zumindest eine zweite Einbettungsschicht (7a) aufweist.

4. Sensor (2) nach einem der vorgenannten Ansprüche,
wobei der Sensor (2) zumindest einen Kontaktierungsbereich (9) aufweist.

5. Sensor (2) nach einem der vorgenannten Ansprüche,
wobei der Sensor (2) zumindest eine Durchkontaktierung (8) aufweist.

6. Sensor (2) nach einem der vorgenannten Ansprüche,
wobei der Sensor (2) zur Signalübertragung und/oder zum Signalempfang eingerichtet ist.

7. Verfahren zur Herstellung eines substratlosen Sensors (2) mit einer Dicke von 1 bis 50 µm auf einer Opferschicht (3),
wobei das Verfahren folgende Schritte aufweist:
a) schichtweiser Aufbau des Sensors (2) mittels verschiedener physikalischer und/oder chemischer Prozesse wobei der Aufbau derart erfolgt, dass jede einzelne Schicht des Sensors (2) eine vorbestimmte mechanisehe Spannung aufweist, wobei die mechanischen Spannungen der einzelnen Schichten des Sensors (2) sich kompensieren, um ein Wölben oder Faltenwerfen zu verhindern,
b) physikalisches und/oder chemisches Entfernen der Opferschicht (3) und
c) Entnehmen des Sensors (2).

8. Verfahren nach Anspruch 7, wobei der schichtweise Aufbau des Sensors (2) das Abscheiden einer Spannungskompensationsschicht (5) mittels CVD und/oder PVD umfasst.

9. Verfahren nach Anspruch 7 oder 8,
wobei nach Schritt a) der folgende Schritt durchgeführt wird:
g) Anbringen von zumindest einer Hilfsschicht (6).

10. Verfahren nach einem der Ansprüche 7 bis 9,
wobei nach einem Anbringen des Sensors (2) auf einer Unterlage der folgende Schritt durchgeführt wird:
h) Entfernen von zumindest einer Hilfsschicht (6).

11. Verfahren nach einem der Ansprüche 8 bis 10,
wobei das Abscheiden der Spannungskompensationsschicht (5) mittels plasmaunterstützter chemischer Abscheidung aus der Dampfphase bei zumindest einer Abscheidungsfrequenz, insbesondere zwei Abscheidungsfrequenzen zum Einstellen der mechanischen Spannung der Spannungskompensationsschicht (5) erfolgt.

## Claims

1. A sensor (2) having a thickness between 1 and 50 µm,
wherein the sensor (2) is without a substrate and comprises at least one stress compensation layer (5) with a predetermined mechanic stress for compensating existing tensile stress and pressures in order to prevent warping or folding.

2. The sensor (2) according to one of the above-mentioned claims,
wherein the sensor (2) comprises at least a first embedding layer (7).

3. The sensor (2) according to one of the above-mentioned claims,
wherein the sensor (2) comprises at least a second embedding layer (7a).

4. The sensor (2) according to one of the above-mentioned claims,
wherein the sensor (2) comprises at least one contacting section (9).

5. The sensor (2) according to one of the above-mentioned claims,
wherein the sensor (2) comprises at least one penetrating contacting (8).

6. The sensor (2) according to one of the above-mentioned claims,
wherein the sensor (2) is configured for signal transmission and/or signal reception.

7. A method for the production of a sensor (2) having a thickness between 1 and 50 µm on a sacrificial layer (3),
wherein the method comprising the following steps:
a) layer-wise construction of the sensor (2) by means of various physical and/or chemical processes, with the construction occurring such that each individual layer of the sensor (2) exhibits a predetermined mechanic stress, with the mechanic stresses of the individual layers of the sensor (2) compensating each other in order to prevent any warping or folding,
b) a physical and/or chemical removal of the sacrificial layer (3), and
c) removal of the sensor (2).

8. The method according to claim 7,
wherein the layer-wise construction of the sensor (2) comprises the deposition of a stress compensation layer (5) by means of CVD and/or PVD.

9. The method according to claim 7 or 8, wherein after step a) the following step is performed:
g) applying at least one auxiliary layer (6).

10. The method according to one of claims 7 to 9,
wherein after an application of the sensor (2) on a support the following step is performed:
h) removal of at least one auxiliary layer (6).

11. The method according to one of claims 8 to 10,
wherein the deposition of the stress compensation layer (5) is performed by means of plasma-enhanced chemical deposition from the vapor phase at least at one deposition frequency, particularly two deposition frequencies, for adjusting the mechanic stress of the stress compensation layer (5).

## Revendications

1. Capteur (2) d'une épaisseur de 1 à 50 µm,
dans lequel le capteur (2) est sans substrat et présente au moins une couche de compensation de tension (5) avec une tension mécanique prédéfinie pour la compensation des tensions de traction ou de compression régnantes afin d'empêcher un gonflement ou un plissement.

2. Capteur (2) selon l'une quelconque des revendications précédentes,
dans lequel le capteur (2) présente au moins une première couche d'enrobage (7).

3. Capteur (2) selon l'une quelconque des revendications précédentes,
dans lequel le capteur (2) présente au moins une deuxième couche d'enrobage (7a).

4. Capteur (2) selon l'une quelconque des revendications précédentes,
dans lequel le capteur (2) présente au moins une zone de contact (9).

5. Capteur (2) selon l'une quelconque des revendications précédentes,
dans lequel le capteur (2) présente au moins un via (8).

6. Capteur (2) selon l'une quelconque des revendications précédentes,
dans lequel le capteur (2) est aménagé pour la transmission de signal et/ou pour la réception de signal.

7. Procédé de fabrication d'un capteur sans substrat (2) d'une épaisseur de 1 à 50 µm sur une couche sacrificielle (3),
dans lequel le procédé présente les étapes suivantes :
a) construction par couche du capteur (2) au moyen de différents processus physiques et/ou chimiques dans lequel la construction se fait de telle sorte que chaque couche individuelle du capteur (2) présente une tension mécanique prédéterminée, dans lequel les tensions mécaniques des couches individuelles du capteur (2) se compensent afin d'empêcher un gonflement ou un plissement,
b) élimination physique et/ou chimique de la couche sacrificielle (3) et
c) retrait du capteur (2).

8. Procédé selon la revendication 7, dans lequel la construction par couche du capteur (2) comprend le dépôt d'une couche de compensation de tension (5) par CVD et/ou PVD.

9. Procédé selon la revendication 7 ou 8,
dans lequel, après l'étape a), l'étape suivante est réalisée :
g) application d'au moins une couche auxiliaire (6).

10. Procédé selon l'une quelconque des revendications 7 à 9,
dans lequel, après une application du capteur (2) sur un support, l'étape suivante est réalisée :
h) élimination d'au moins une couche auxiliaire (6).

11. Procédé selon l'une quelconque des revendications 8 à 10,
dans lequel le dépôt de la couche de compensation de tension (5) se fait par dépôt chimique assisté par plasma en phase vapeur à au moins une fréquence de dépôt, en particulier deux fréquences de dépôt pour le réglage de la tension mécanique de la couche de compensation de tension (5).
